Europäisches Patentamt

European Patent Office

Office européen des brevets

(11) Publication number: **0 132 326**
**A2**

(12) # EUROPEAN PATENT APPLICATION

(21) Application number: **84304427.2**

(22) Date of filing: **28.06.84**

(51) Int. Cl.⁴: **H 01 L 21/314**

(30) Priority: **17.02.84 US 581115**
**29.06.83 US 509210**

(43) Date of publication of application: **30.01.85**
**Bulletin 85/5**

(84) Designated Contracting States: **AT BE CH DE FR GB IT LI LU NL SE**

(71) Applicant: **STAUFFER CHEMICAL COMPANY, Westport Connecticut 06881 (US)**

(72) Inventor: **Baumann, John Andrew, 112 Pine Avenue, Ossining NY 10562 (US)**
Inventor: **Raccah, Paul Mordecai, 7521 North Albany, Chicago Ill. 60645 (US)**
Inventor: **Serreze, Harvey Bruce, Salem Road, Pound Ridge NY 10576 (US)**
Inventor: **Olego, Diego Jose, 28T Scenic Drive, Croton-on-Hudson N.Y. 10520 (US)**
Inventor: **Schachter, Rozalie, 75-14 173rd Street, Flushing N.Y. 11366 (US)**
Inventor: **Spicer, William Edward, 785 Mayfield Avenue, Stanford California 94305 (US)**

(74) Representative: **Smith, Sydney et al, Elkington and Fife High Holborn House 52/54 High Holborn, London WC1V 6SH (GB)**

(54) Passivation and insulation of III-V devices with pnictides, particularly amorphous pnictides having a layer-like structure.

(57) A semiconductor characterised in that it has a pnictide-rich layer on a surface thereof is disclosed, as is the production thereof.

A new form of pnictide characterized in that it comprises a layer of amorphous pnictide-rich material having a layer-like local order.

The accompanying illustration shows a comparison of Raman spectra from which it may be concluded that the local order of the present fibres is the amorphous counterpart of the puckered layer-like, sheet-like crystalline structure of black phosphorus.

In general terms, pnictide thin films, particularly phosphorus, grown on III-V semiconductors, particularly InP, GaP and GaAs, are amorphous and have a novel layer-like, puckered sheet-like local order. The thin films are typically 400 Angstroms ($4 \times 10^{-6}$ cms) thick and grown preferably by molecular beam deposition, although other processes, such as vacuum evaporation, sputtering, chemical vapour deposition and deposition from a liquid melt, may be used. The layers may be grown on the ‹100›, ‹110› and ‹111› surface of III-V crystals. The pnictide layer reduces the density of surface states and allows the depletion layer to be modulated, the surface barrier reduced, the electron concentration at the surface increased and there is a decrease in the surface recombination velocity and an increase in the photoluminescence intensity. The layers

COMPARISON OF THE RAMAN SPECTRUM OF THE FILM GROWN AT $T_s \simeq 20°C$ WITH THEORETICAL PREDICTION FOR THE PUCKERED LAYER STRUCTURE

may be utilized in MIS and Metal-semiconductor (Schottky) devices, for example, to insulate and passivate MISFETS, to passivate MESFETS, to reduce the surface current component of the reverse bias dark current in P–I–N and avalanche diodes and to improve performance of opto-electronic devices, such as light-emitting diodes, lasers, solar cells, photo-cathodes and photo-detectors. The pnictide layer may be applied to intermetallic and compound semiconductors having a pnictide component. The pnictides may be phosphorus, arsenic, antimony or bismuth, or combinations thereof.

The present invention represents an advance over the prior art.

Passivation and insulation of III-V devices with pnictides, particularly amorphous pnictides having a layer-like. structure

This invention relates to the passivation and insulation of III-V devices with pnictides, particularly amorphous pnictides having a layer-like (more particularly puckered sheet-like) structure; it also relates to compound, intermetallic semiconductors, particularly III-V semiconductors; to pnictide and polypnictides, particularly phosphorus and polyphosphides; to MIS and metal-semiconductor (Schottky) devices, particularly MISFETS and MESFETS; to. light absorbing diodes, particularly P-I-N and avalanche detector diodes, solar cells and photo-cathodes; and to light emitting diodes and lasers.

For further information, reference may be made to, for example, GP-A- 2,113,663 and to the related applications filed herewith, in particular those based on USSN 581,139, USSN 509,157, USSN 509,175, USSN 581,104, USSN 509,158, USSN 581,103, USSN 581,105, USSN 581,102 and USSN 581,101.

III-V semiconductors have desirable properties of higher carrier mobility than silicon. They have been successfully employed in metal semiconductor (Schottky) devices, but have not been commercially employed in the more widely useful metal-insulator-semiconductor (MIS) devices. A reason for this is that the native oxides of the III-V materials do not form thermodynamically stable layers thereon in the way that silicon dioxide layers may be formed on silicon to form MIS devices. Silicon oxynitride and $Si_3N_4$ have been used as an insulating layer on III-V materials with limited success.

The passivation of III-V semiconductors has been a problem for the same reasons.

Thus, it is highly desirable to find a material and a means of production thereof, which readily forms an insulating and passivating layer on III-V materials and thus provide the basis for the formation of MIS and Schottky devices, particularly MISFETS AND MESFETS.

Similarly, it is desirable to reduce the surface component of currents in III-V opto-electronic devices by passivating the surface thereof.

It is also desirable to decrease the carrier recombination velocity at the surface of III-V opto-electronic devices.

It is therefore an object of the present invention to provide insulating layers for semiconductors comprising pnictides.

Another object of the present invention is to provide passivating layers for semiconductors comprising pnictides.

A further object of the present invention is to provide a new form of amorphous pnictides.

Still another object of the present invention is to provide improved MIS and Schottky devices; including MISFETS and MESFETS.

A still further object of the present invention is to provide improved opto-electronic devices, including light-emitting and light-collecting devices, such as P-I-N and avalanche diodes, solar cells, photocathodes, light-emitting diodes and lasers.

The present invention provides a semiconductor characterised in that it has a pnictide-rich layer on a surface thereof.

The semiconductor may be a III-V semiconductor or a compound semiconductor comprising a pnictide. For example, the semiconductor in accordance with the present invention may be a metal-insulator-semiconductor device, a metal-semiconductor device, a MISFET, a MESFET, an opto-electronic device, a light-emitting device, a light-receiving device, a P-I-N photodiode, an avalanche photodiode, a solar cell, a laser or a photocathode. In these cases, the pnictide layer acts as an insulator and/or passivates the surface of the semiconductor and/or reduces the density of surface states at the surface of the semiconductor and/or reduces the recombination velocity of charge carriers at the surface of the semiconductor and/or increases the photoluminescence of the semiconductor.

The pnictide-rich layer may extend across layers of differing composition. The present layer may comprise a polypnictide. The semiconductor material may be GaAs, Inp or GaP. The pnictide may be phosphorus, arsenic, antimony or bismuth. It may be an alkali metal (e.g. K) pnictide. For example, the pnictide may be a polypnictide having the formula $MP_x$ wherein M represents an alkali metal, P represents a pnictide and x ranges from 15 to infinity. Alternatively, it may be elemental.

The pnictide may have a layer-like local order, which is preferably puckered sheet-like. A further aspect of the present invention relates to such new form pnictide, which may be formed below 300°C, preferably at $\sim$ 20°C.

According to the present invention, the pnictide layer is deposited, for example by co-evaporating _in vacuo_ a pnictide and an alkali metal, by deposition from $P_2$ vapour species, by sputtering, by molecular beam deposition, by vacuum deposition or by chemical vapour deposition.

It has been discovered that insulating, passivating and surface recombination velocity-reducing pnictide-rich layers may be formed on III-V semiconductor substrates by various methods that pnictide-rich layers may be formed on any substrate. These include vacuum coevaporation, sputtering, chemical vapour deposition, two-source vapour transport, deposition from a liquid melt and molecular beam deposition, which produces the best results.

In particular, there has been deposited an alkali metal polyphosphide layer, namely $KP_{15}$, on gallium

0132326

- 4 -

arsenide, gallium phosphide, indium phosphide and Si. There have also been deposited insulating and passivating layers of high x alkali metal polyphosphides having the formula $MP_x$, wherein x is greater than 15, on these materials. For all practical purposes, such very high x materials are elemental phosphorus.

Elemental phosphorus layers have also been deposited on substrates of gallium arsenide, gallium phosphide and indium phosphide using these same processes. Other III-V semiconductors may also be used as substrates.

It is contemplated that other high pnictide polypnictides, particularly alkali metal polypnictides and other elemental pnictides comprising Group V atoms will also form useful insulating layers and semiconductors comprising a pnictide. These pnictide materials are insulators or very high resistivity semiconductors, good film-formers and the pnictides, being Group V materials, provide chemical continuity, matching order and adhesion to the Group V atoms of the Group V-containing semiconductors.

The present insulating layers have a resistivity of greater than $10^{+10}$ ohm-cm. which is greater than the resistivity of the III-V materials.

Another $Si_3N_4$ layer has been successfully added on top of a pnictide layer of III-V materials to provide a higher breakdown voltage.

The amorphous layers employed have a local order not found before in amorphous pnictide films deposited on a III-V substrate. This is a layer-like puckered sheet-like structure similar to black phosphorus. This structure apparently forms at low effective energies at the surface during the deposition. Thus, invacuum evaporation and molecular beam deposition when the surface is maintained below approximately 200°C, this new layer-like puckered sheet amorphous polyphosphide material forms. Similarly, at low energies and at temperatures below approximately 300°C, the same material forms in a sputterer. The material is formed by deposition from excess phosphorus supplied as $P_4$ vapour, which is cracked to $P_2$ vapour by a heated cracker in the case of vacuum deposition and molecular beam deposition and is cracked by the plasma in a sputterer.

The surface layers according to the present invention reduce the density of surface states, allow modulation of the depletion layer, reduce the surface barrier, increase the surface electron concentration, increase the photoluminescence intensity and decrease the surface carrier recombination velocity.

The pnictide layers according to the present invention may be used to insulate and passivate MIS and Schottky devices, particularly MISFETS and MESFETS, to reduce the surface current between different layers in III-V devices, such as the dark current in reverse biased light-detecting diodes, particularly P-I-N and avalanche diodes, and to increase the efficiency of light-emitting and light-collecting opto-electronic devices, particularly solar cells, photocathodes, light-emitting diodes, lasers and photo-detectors.

For a fuller understanding of the nature and objects of the present invention reference may be made to the accompanying illustrative drawings wherein:

Figure 1 is a plot Raman spectra of films grown at different substrate temperatures;

Figure 2 is a comparison of the Raman spectra of the film grown at low temperature with the theoretical prediction for a puckered sheet layer-like structure;

Figure 3 is a plot of normalized capacitance versus voltage for indium phosphide having a insulating layer thereon according to the present invention;

Figure 4 is a plot of the density of surface states versus energy for various possible insulating and passivating layers on indium phosphide according to the present invention;

Figure 5 is a plot of normalized capacitance versus voltage for gallium arsenide having a layer deposited thereon according to the present invention;

Figure 6 is a comparison of the intensities of the Raman spectra of gallium arsenide with and without a film according to the present invention deposited thereon;

Figure 7 is a comparison of the line shape of the photoluminescence of gallium arsenide with and without a film according to the present invention deposited thereon;

Figure 8 is a comparison of the intensities of the photoluminescence of gallium arsenide with and without a film according to the present invention deposited thereon;

Figure 9 is a diagrammatic cross-section of a MISFET according to the present invention;

Figure 10 is a diagrammatic cross-section of a MESFET according to the present invention;

Figure 11 is a diagrammatic cross-section of a MISFET according to the present invention;

Figure 12 is a diagrammatic cross-section of a photodetecting diode according to the present invention;

Figure 13 is a diagrammatic cross-section of another photo-detecting diode according to the present invention;

Figure 14 is a diagrammatic cross-section of a light-collecting device according to the present invention; and

Figure 15 is a diagrammatic cross-section of a light-emitting device according to the present invention.

The same reference characters refer to the same elements throughout the several view of the drawings.

It has now been found that pnictides films grown at relatively low temperatures, below 300°C at low powers in sputtering and below 200°C in vacuum evaporation and molecular beam deposition, have a puckered sheet-like, layer-like structure similar to black phosphorus. These amorphous films are deposited from phosphorus in the form of $P_4$ vapour which is cracked by the plasma in sputtering and by a heated cracker in vacuum evaporation and molecular beam deposition.

Reference may be made to the above-mentioned related applications, in particular those based on USSN 581,139, USSN 581,103 and USSN 581,104, for a fuller understanding of these processes.

It has now been found that pure phosphorus films and presumably films of other pure pnictides, form the best insulation and passivating layers on III-V materials. This is because the pnictide layer is capable of matching the pnictides within the III-V semiconductors. Poly-pnictides, particularly $MP_x$, wherein M represents an alkali metal and x ranges from 15 to infinity, may also be used. The present insulating and passivating films may be used on any compound or intermetallic semiconductor comprising a pnictide. Such films have been deposited on the <111>, <100> and <110> of various III-V semiconductors.

The best results to date have been with phosphorus films having a typical thickness of approximately 400Å ($4 \times 10^{-6}$ cms) deposited on III-V semiconductors solely from a phosphorus source by molecular beam deposition.

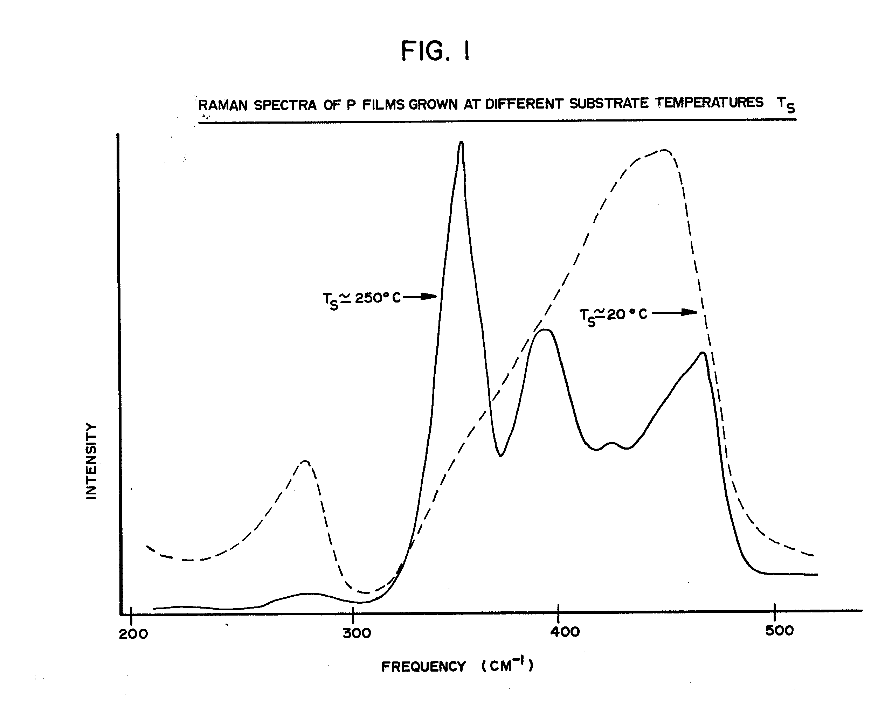

Accompanying Figure 1 illustrates a comparison of the Raman spectra of polyphosphide films grown by vacuum evaporation (250°C) and molecular beam deposition (20°C). The solid line spectrum, when the substrate is at 250°C, is typical spectrum similar to amorphous red phosphorus indicating a local order comprising parallel pentagonal tubes. The dotted line spectrum of the film formed at approximately 20°C indicates a much different local order. Films produced by sputtering at temperatures less than that or equal to approximately 300°C have the same Raman spectra as the 20°C molecular beam deposition results illustrated in Figure 1.

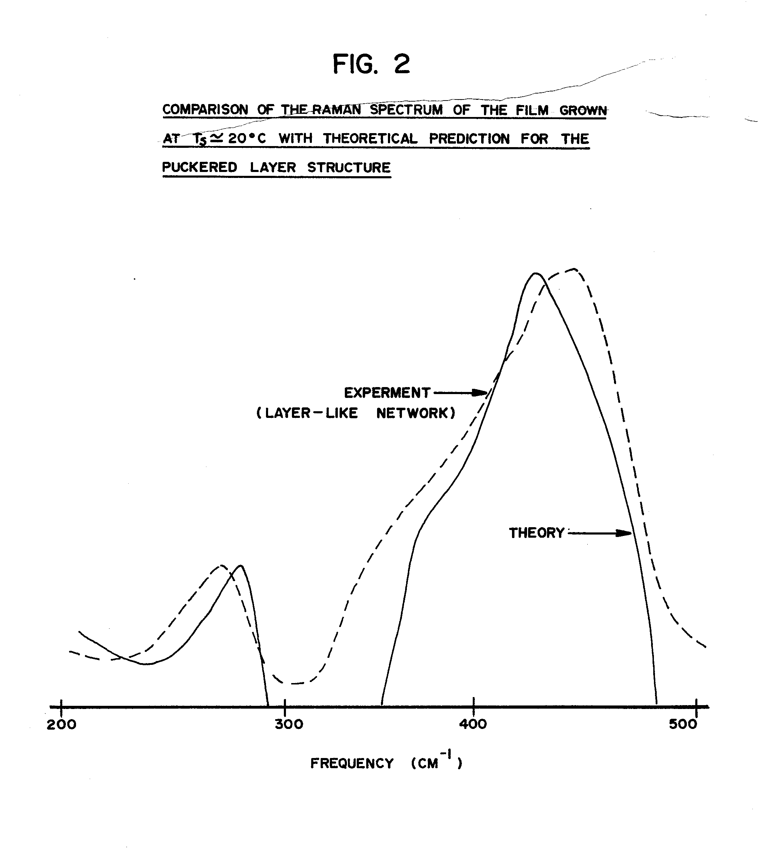

Accompanying Figure 2 illustrates a comparison of the Raman spectrum of film grown at a substrate temperature of 20°C, shown in dotted lines, with a theoretical prediction of the spectrum of a puckered sheet-like, layer-like, structure similar to black phosphorus.

It is concluded that the local order of these films is the amorphous counterpart of the puckered layer-like, sheet-like, crystalline structure of black phoshphorus.

This local order is simpler than that of the films described in the above-identified related applications which have a local order comprising pentagonal tubes. It has been found that the energy band gap of this new form of amorphous phosphorus according to the present invention is approximately 1.7eV versus a band gap of approximately 2.0eV for amorphous red phosphorus. No photoconductivity or photoluminescence has been detected from phosphorus films of this type. The films are shiny, hard and stable.

It is concluded that these films would be good candidates for insulating and passivating layers of III-V materials.

Results of electrical measurements of phosphorus thin films grown on indium phosphide and gallium arsenide

Amorphous thin films of phosphorus of a typical thickness of 400Å ($4 \times 10^{-6}$ cms) have been grown by molecular beam deposition on the <100> surface of InP and the <100> surface of GaAs, the substrates being maintained at room temperature, approximately 23°C.

The InP is specified by the manufacturer to contain $2 \times 10^{15}$ free electrons per cubic centimetre; the gallium arsenide to contain $2 \times 10^{16}$ free electrons per cubic centimetre.

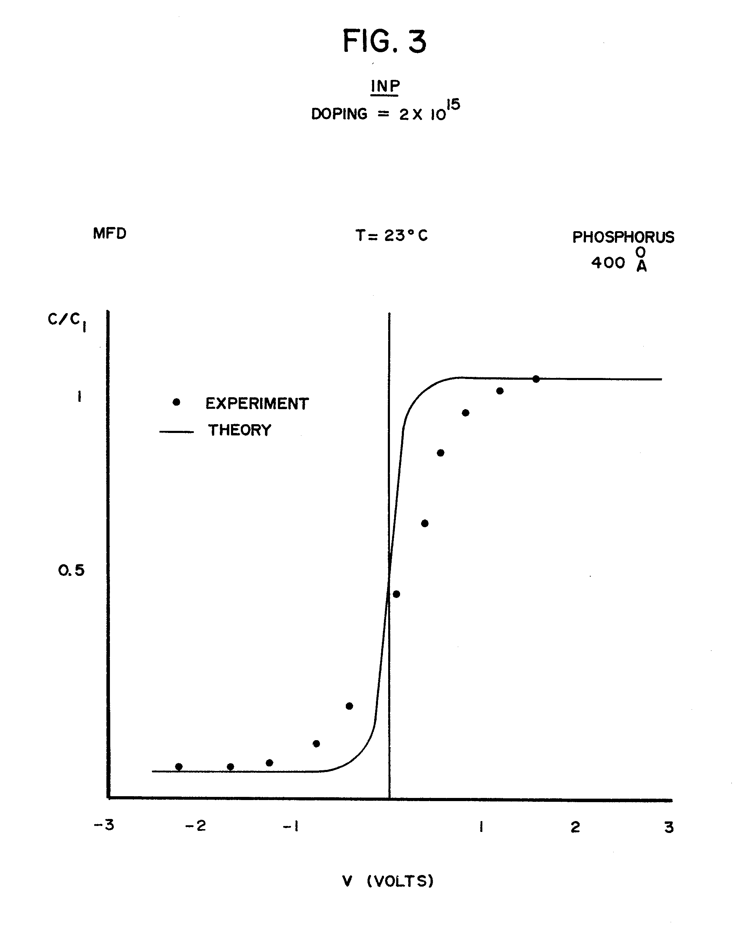

Accompaying Figure 3 illustrates a comparison of the theoretical (solid line) and experimental (dotted line) data plots of normalized capacitance versus voltage for an MIS structure on InP. The solid line (theoretical) curve is computed for the case of ideal conditions, namely a perfect insulation and a negligibly small density of surface states.

Excellent agreement between experiment and theory is shown in these high frequency C-V curves. This indicates that a low density of surface states has been achieved by the phosphorus layer on the InP and that the phosphorus layer allows modulation of the depletion layer.

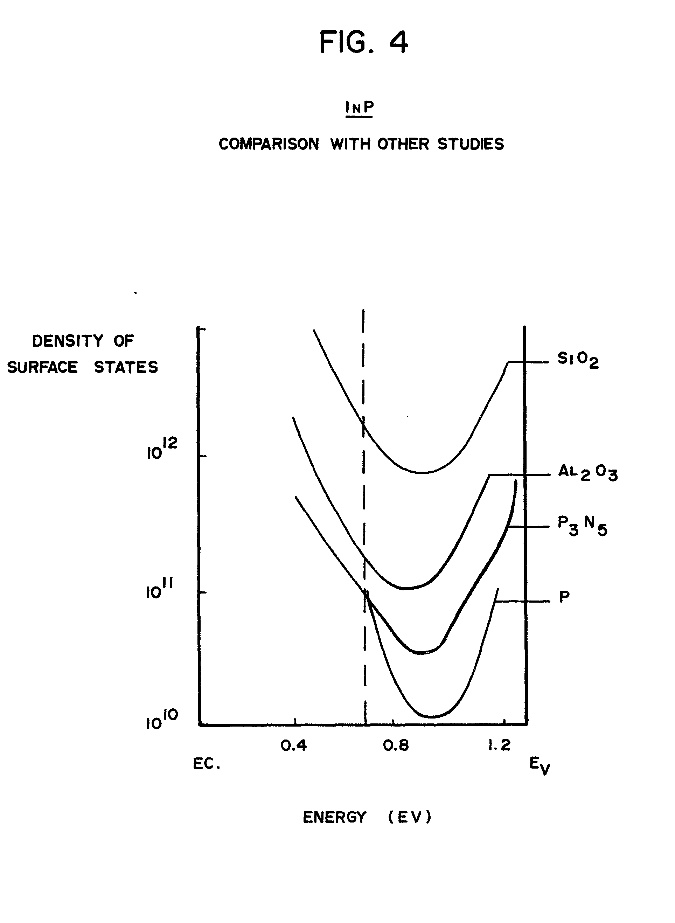

The density of the surface states may be calculated by Terman's method. Accompanying Figure 4 illustrates a comparison of the density of surface states for passivation with $SiO_2$, $Al_2O_3$, $P_3N_5$ and P (present phosphorus layer) and it may be seen that there has now been achieved the lowest density of surface states reported on III-V materials.

($E_C$ in Figure 4 is the energy of the conduction band and $E_V$ is the energy of the valence band.)

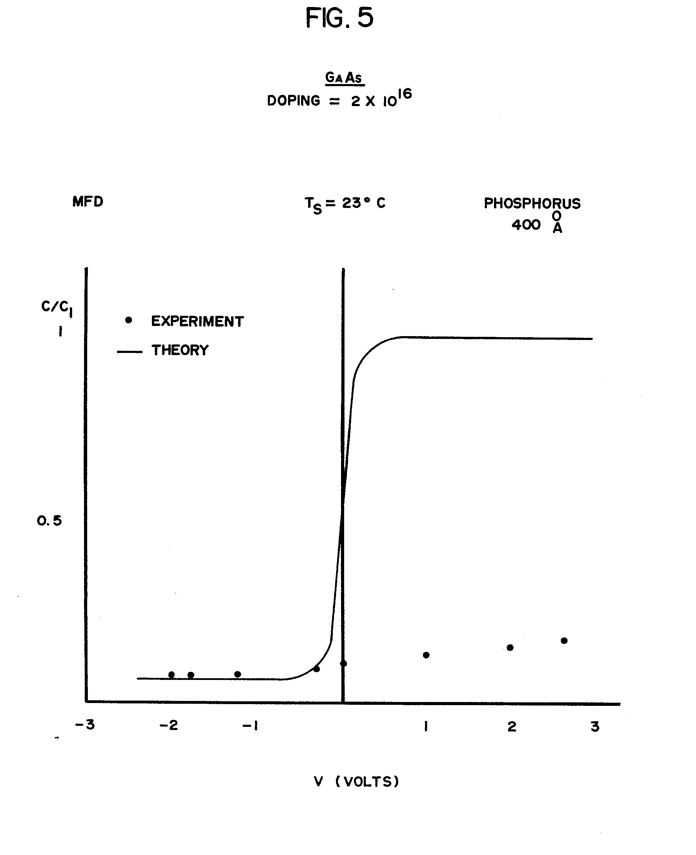

Accompanying Figure 5 illustrates such a comparison for GaAs. It will be seen that the depletion layer has been modulated, but that the density of surface states has not been reduced as much as in the case of InP.

Passivation studies of phosphorus layers on GaAs

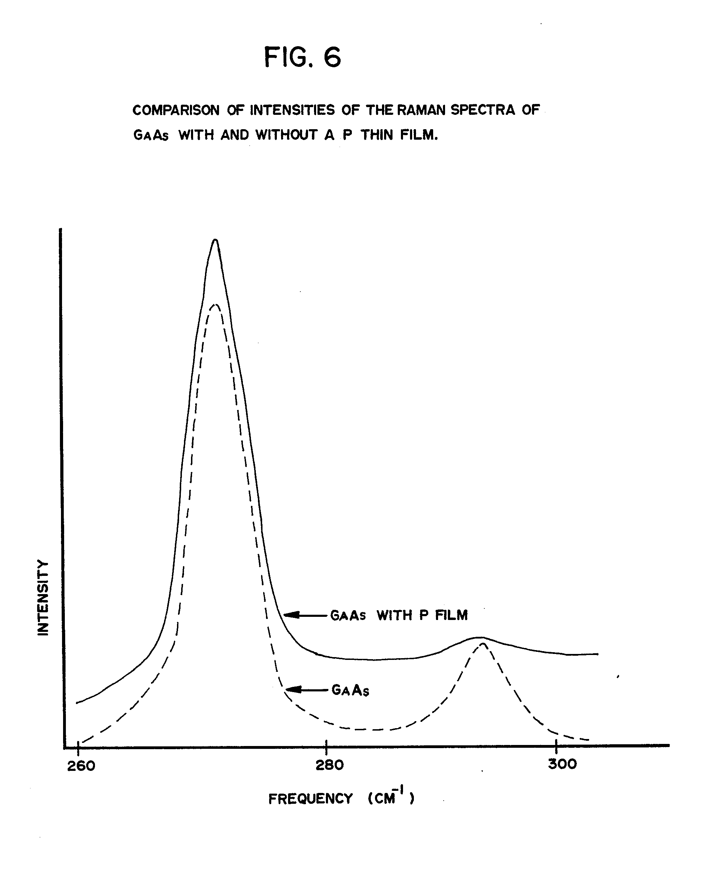

Accompanying Figure 6 illustrates a comparison of the intensities of the Raman spectra of GaAs with and without the present phosphorus thin film layer. That of the plain GaAs is indicated by a dotted line and GaAs having the present phosphorus film is indicated by a solid line.

These data suggests a reduction of the surface barrier of the GaAs when the phosphorus barrier is present. This indicates that the phosphorus layer may be used in MIS and Schottky devices and for the improvement of the performance of opto-electronic devices.

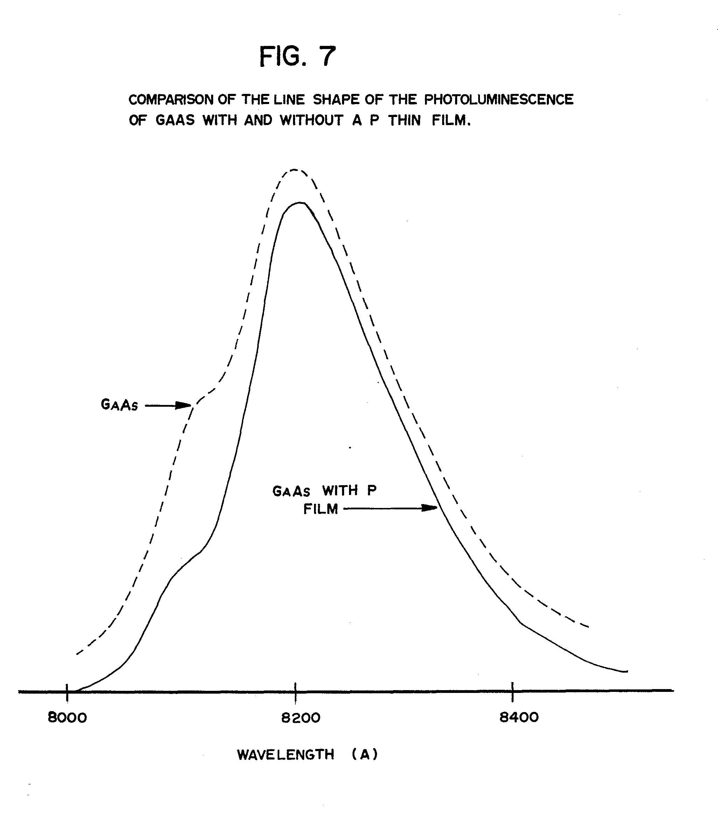

Accompanying Figure 7 illustrates a comparison of the line shape of the photoluminescence of GaAs with and without a phosphorus thin film; (GaAs alone is shown dotted; GaAs with phosphorus in solid).

It may be concluded from this diagram that there is an increase of the electron concentration at the surface of the GaAs when a phosphorus thin film is present. Since this behaviour is expected if the surface barrier has decreased, this is consistent with the results illustrated in Figure 6.

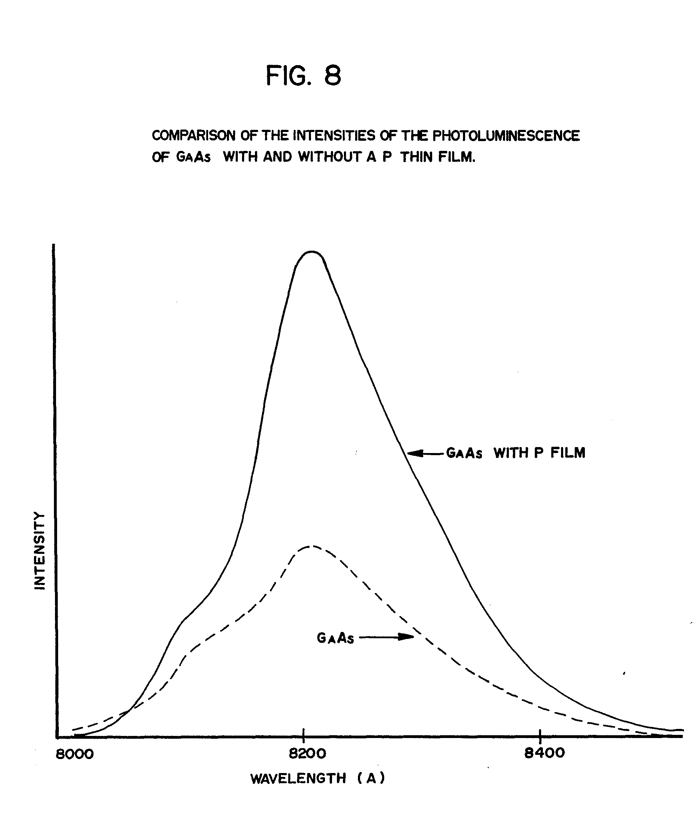

Accompanying Figure 8 illustrates that there is an increase in the intensity of the photoluminescence produced from GaAs when phosphorus thin film is present. The photoluminescence intensity of GaAs alone is shown by the dotted line and intensity with the phosphorus film is shown by the solid line.

This increase in photoluminescence again indicates a decrease in number of surface states when the phosphorus thin film is present. This result is consistent with Figures 6 and 7.

The phosphorus film for Figures 6, 7 and 8 was grown on the <111> surface of GaAs specified by the manufacturer to have $7 \times 10^{17}$ free electrons per cubic centimetre.

It is concluded that the GaAs surface barrier has been reduced when a phosphorus thin film having a layer-like, puckered sheet-like local order is deposited on the GaAs.

The present experiments indicate a reduction of one order of magnitude in the density of the surface states.

The increase of the photoluminescence intensity which has been noted is extremely important for opto-electronic devices. It means that there is a decrease in the surface recombination velocity.

Thus, it has been shown that a polypnictide surface film having a layer-like, puckered sheet-like local order deposited upon III-V semiconductors produces a reduction in the density of surface states, allows the modulation of the depletion layer, reduces the surface barrier, increases the free electron concentration at the surface, increases the photoluminescence intensity and decreases the surface recombination velocity.

Devices according to the present invention

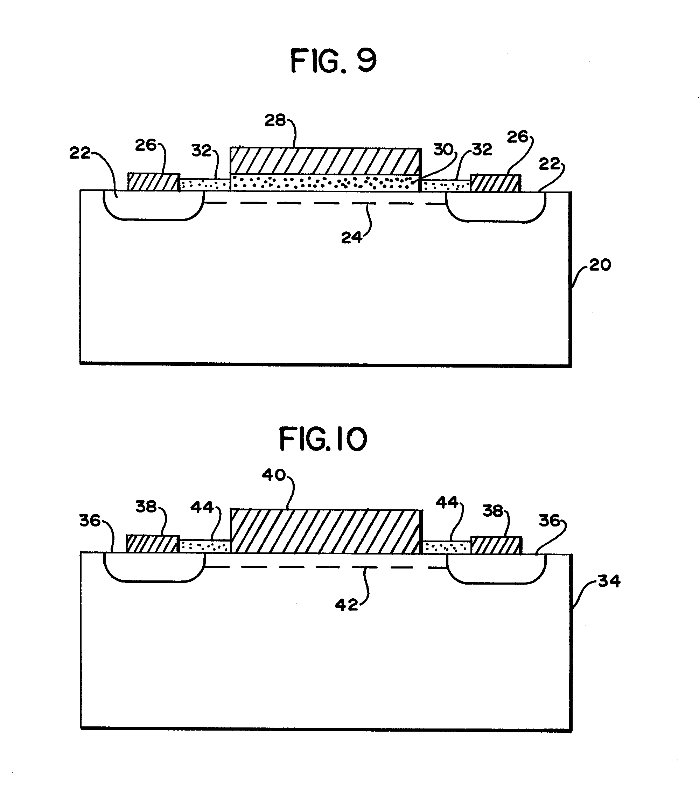

Now, referring to accompanying illustrative Figure 9, a MISFET according to the present invention comprises a body of III-V semiconducting material 20, islands 22 of high conductivity, a conduction channel 24 therebetween, source and drain metal contacts 26, gate metal contact 28, insulating layer 30 and passivating layers 32.

According to the present invention, the I layer 30 and the passivating layers 32, which may be unitary and deposited on the substrate 20 at the same time, are the new amorphous layer-like phosphorus or other layer-like pnictide-rich materials, such as $MP_{15}$, wherein M represents an alkali metal, and $MP_x$, wherein M represents an alkali metal and x varies from 15 to infinity, particularly where the alkali metal is potassium.

Accompanying Figure 10 illustrates a MESFET according to the present invention. This comprises a III-V semiconductor body 34, islands 36 of high conductivity, source and drain contacts 38, gate contact 40, conduction channel 42 and passivating layers 44 according to the present invention. The layers 44 reduce the surface currents from the source and the drain to the gate.

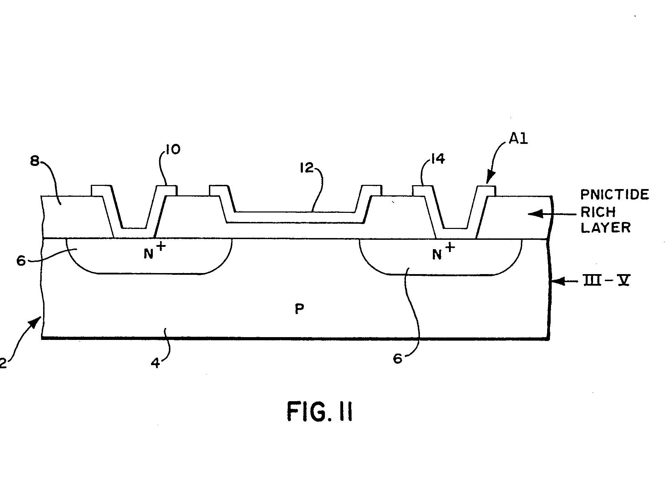

According to the present invention, another MIS device utilizing a III-V substrate may be formed as illustrated in accompanying Figure 11. There, the III-V substrate, generally indicated at 2, is appropriately doped to form P regions 4 and N regions 6 therein. The polypnictide or elemental pnictide layer 8 is then deposited thereon, according to the present invention, appropriately masked and etched, and then a metal, such as aluminium, is deposited to form drain 10, gate 12 and source 14. Those skilled in the art will realize that many other MIS configurations and devices may be fabricated using a pnictide-rich insulating layer according to the present invention.

Most III-V semiconductor junction devices have either a planar or mesa configuration where the edges of the junction of junctions are exposed on the device surface. For some critical applications, e.g. PIN or avalanche photodetector diodes for lightwave communications, it is imperative that the dark current, i.e. current with no illumination, under operating reverse bais be as low as possible in order to ensure low device noise. Since the surface current component of this dark current may be significant, it is desirable to minimize the surface current by "passivation" of the surface, i.e. reduction or elimination of surface current paths. This may be done by depositing a thin film of a suitable insulating material onto the exposed device surface. Materials currently used for this on III-V devices include $SiO_2$, $Si_3N_4$, polyimide and photoresist, but none are able controllably and reproducibly to reduce the surface current to the very low values needed.

According to the present invention, there is used a thin film of polypnictide material, e.g. phosphorus, $MP_{15}$ or $MP_x$ wherein x is 15 or greater and M represents an alkali metal, such as potassium, for III-V devices of this type. These materials have: (1) good physical and chemical stability; (2) high electrical resistivity; and (3) a preferred tendency or "affinity" for the polypnictides to grow on III-V material substrates.

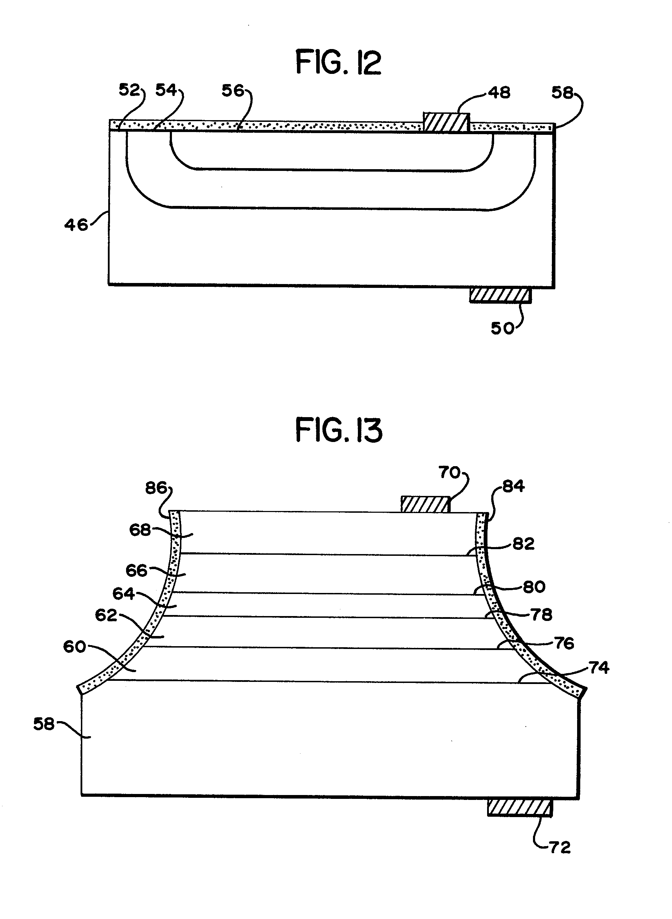

Now, referring to accompanying illustrative Figure 12, a body of III-V semiconductor material 46 containing various layers has metal contacts 48 and 50 deposited thereon. To reduce the surface current component which would provide leakage between the layers 52, 54 and 56, a film 58 of pnictide is deposited according to the present invention.

The device illustrated in Figure 12 may be, for example, a P-I-N photo-detecting diode or an avalanche diode.

The devices illustrated in Figure 12 has a planar structure. A device having a mesa structure is illustrated in accompanying Figure 13. It comprises various layers 58, 60, 62, 64, 66 and 68 of III-V material and metal contacts 70 and 72. Again, in order to prevent surface currents across the interfaces 74, 76, 78, 80 and 82 between the layers 58, 60, 62, 64, 66 and 68, there are provided pnictide-rich passivating layers 84 and 86.

The device illustrated in Figure 13 may be, for example a photo-detecting P-I-N diode or an avalanche diode.

Both Figures 12 and 13 illustrate the use of the present pnictide layers to lower surface currents in opto-electronic devices.

Another important application of the present invention to opto-electronic devices is based on the fact that the present pnictide layers reduce the surface recombination velocity at the surfaces of III-V semi-conductors to which they are applied. An increase by a factor of 2.5 in the measured photoluminescence intensity of heavily doped GaAs with an amorphous thin film of layer-like puckered sheet-like phosphorus grown on the <111> surface has been noted. This increase in the photoluminescence intensity indicates a decrease recombination velocity at the surface. It is known that the smaller the surface recombination velocity the better the performance of the opto-electronic devices, such as light-emitting diodes, lasers, solar cells, photo- cathodes and photo-detectors utilizing III-V semiconductors.

According to the present invention, the layer of the present layer-like form of pnictide-rich material would be applied to the light-emitting or light-collecting surface of the opto-electronic device.

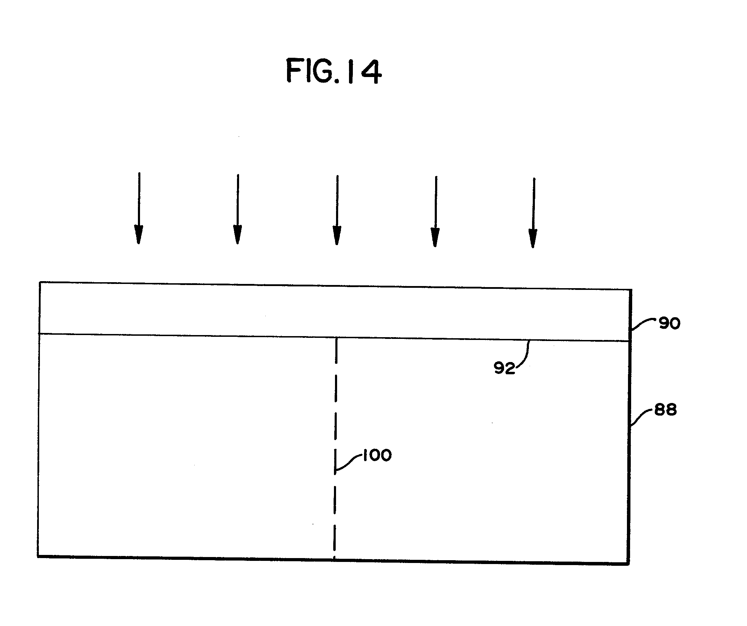

Thus, referring accompanying illustrative Figure 14, a light-collecting device according to the present invention comprises a body 88 of a compound intermetallic or III-V semiconductor comprising a pnictide and a pnictide-rich layer 90 deposited on the light-collecting surface 92 thereof.

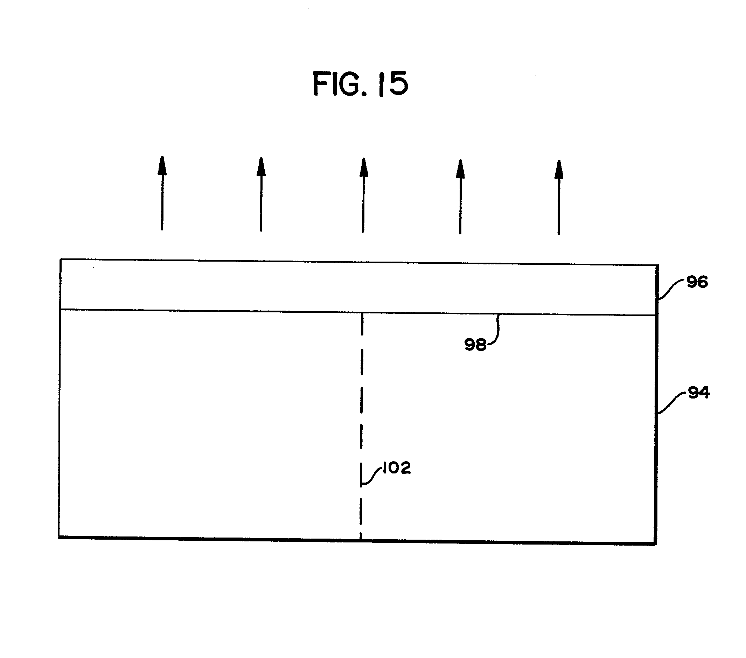

Similarly, as illustrated in accompanying Figure 15, a light-emitting device according to the present invention again comprises a body 94 of a compound intermetallic semiconductor comprising a pnictide-rich layer 96 deposited on the light-emitting surface 98 thereof. If the light-collecting or light-emitting device has two or more semiconductor layers which emerge on the surfaces 92 or 98, respectively, as indicated by the intersections between them 100 and 102, respectively, then the layers 90 and 96, respectively, also reduce surface currents. The layers 90 and 96 may also be used to reduce surface currents between contacts, not shown, as in the devices illustrated in accompanying Figures 9 to 13.

Thus, there has been disclosed the insulation and passivation of compound and intermetallic semiconductors comprising a pnictide, particularly III-V semiconductors and a new form of pnictide-rich thin films having a layer-like, puckered sheet-like local order; it has been shown that such layers, when deposited on pnictide-based semiconductors, reduce the density of surface states, allow modulation of the depletion layer, decrease the surface barrier, increase the carrier concentration at the surface, increase the photoluminescence and decrease the carrier recombination velocity at the surface; there have been disclosed MIS and Schottky devices, particularly MISFETS AND MESFETS, utilizing pnictide-rich layers for insulation and passivation and various electro-optical devices utilizing such layers for insulation, passivation, increased performance and lifetime.

The semiconductors utilized in the present invention comprising pnictides are commonly call intermetallic or compound. III-V semiconductors which are compound, intermetallic semiconductors may comprise elements from Group III and Group V of the periodic Table, such as the binary semiconductor aluminium phosphide, aluminium arsenide, aluminium antimonide, gallium phosphide, gallium arsenide, gallium antimonide, indium phosphide, indium arsenide and indium antimonide, the ternary and the quaternary semiconductors. By "pnictide" is meant those elements from Group V of the Periodic Table, namely nitrogen, phosphorus, arsenic, antimony and bismuth.

CLAIMS:

1. A semiconductor characterised in that it has a pnictide-rich layer on a surface thereof.

2. A semiconductor as claimed in claim 1 wherein it is a III-V semiconductor.

3. A semiconductor as claimed in claim 1 or claim 2 wherein it is a compound semiconductor comprising a pnictide.

4. A semiconductor as claimed in any of claims 1 to 3 wherein the layer acts as an insulator and/or passivates the surface of the semiconductor and/or reduces the density of surface states at the surface of the semiconductor and/or reduces the recombination velocity of charge carriers at the surface of the semiconductor and/or increases the photoluminescence of the semiconductor.

5. A semiconductor as claimed in any of claims 1 to 4 which is a metal-insulator-semiconductor device, a metal-semiconductor device, a MISFET, a MESFET, an opto-electronic device, a light-emitting device, a light-receiving device, a P-I-N photodiode, an avalanche photodiode, a solar cell, a laser or a photocathode.

6. A semiconductor as claimed in any of claims 1 to 5 wherein the pnictide-rich layer extends across layers of differing composition.

7. A semiconductor as claimed in any of claims 1 to 6 wherein the layer comprises a polypnictide.

8. A semiconductor as claimed in any of claims 1 to 7 wherein the semiconductor is GaAs, InP or GaP.

9. A semiconductor as claimed in any of claims 1 to 8 wherein the pnictide is phosphorus, arsenic, antimony or bismuth.

10. A semiconductor as claimed in any of claims 1 to 9 wherein the pnictide is an alkali metal pnictide.

11. A semiconductor as claimed in claim 10 wherein the alkali metal is potassium.

12. A semiconductor as claimed in any of claims 1 to 11 wherein the pnictide is a polypnictide having the formula $MP_x$ wherein M represents an alkali metal, P represents a pnictide and x ranges from 15 to infinity.

13. A semiconductor as claimed in any of claims 1 to 9 wherein the pnictide is elemental.

14. A semiconductor as claimed in any of claims 1 to 13 wherein the pnictide has a layer-like local order.

15. A semiconductor as claimed in claim 14 wherein the layer-like local order is puckered sheet-like.

16. A process for the production of a semiconductor as claimed in any of claims 1 to 15 characterised in that it comprises depositing a pnictide-rich layer.

17. A process as claimed in claim 16 wherein the layer is formed by co-evaporating in vacuo a pnictide and an alkali metal, by deposition from $P_2$ vapour species, by sputtering, by molecular beam deposition, by vacuum deposition or by chemical vapour deposition.

18. A new form of pnictide characterised in that it comprises a layer of amorphous pnictide-rich material having a layer-like local order.

19.  A pnictide form as claimed in claim 18 wherein the local order is puckered sheet-like.

20.  A pnictide form as claimed in claim 18 or claim 19 wherein it is formed on a substrate at a temperature of below 300°C.

21.  A pnictide form as claimed in claim 20 wherein it is formed on a substrate at substantially 20°C.

# FIG. 1

RAMAN SPECTRA OF P FILMS GROWN AT DIFFERENT SUBSTRATE TEMPERATURES $T_S$

$T_S \simeq 250°C$

$T_S \simeq 20°C$

INTENSITY

FREQUENCY $(CM^{-1})$

1/13

0132326

# FIG. 2

COMPARISON OF THE RAMAN SPECTRUM OF THE FILM GROWN
AT $T_S \simeq 20°C$ WITH THEORETICAL PREDICTION FOR THE
PUCKERED LAYER STRUCTURE

EXPERMENT———→
(LAYER-LIKE NETWORK)

THEORY———→

200    300    400    500

FREQUENCY (CM$^{-1}$)

## FIG. 3

INP
DOPING $= 2 \times 10^{15}$

FIG. 4

$\underline{InP}$

COMPARISON WITH OTHER STUDIES

ENERGY (EV)

# FIG. 5

$$\frac{GaAs}{DOPING = 2 \times 10^{16}}$$

MFD

$T_S = 23°\, C$

PHOSPHORUS
400 $\overset{O}{A}$

$C/C_1$

• EXPERIMENT

— THEORY

V (VOLTS)

## FIG. 6

COMPARISON OF INTENSITIES OF THE RAMAN SPECTRA OF
GaAs WITH AND WITHOUT A P THIN FILM.

GaAs WITH P FILM

GaAs

INTENSITY

FREQUENCY $(CM^{-1})$

260        280        300

## FIG. 7

COMPARISON OF THE LINE SHAPE OF THE PHOTOLUMINESCENCE
OF GAAS WITH AND WITHOUT A P THIN FILM.

GaAs

GaAs WITH P
FILM

8000          8200          8400

WAVELENGTH (A)

## FIG. 8

COMPARISON OF THE INTENSITIES OF THE PHOTOLUMINESCENCE
OF GaAs WITH AND WITHOUT A P THIN FILM.

## FIG. 9

## FIG. 10

FIG. II

0132326

## FIG. 12

## FIG. 13

0132326

# FIG.14

↓ ↓ ↓ ↓ ↓

90

92

88

100

## FIG. 15